# EUROPÄISCHE PATENTSCHRIFT

(11) **EP 4 205 893 B1**
(45) Veröffentlichungstag und Bekanntmachung des Hinweises auf die Patenterteilung: **30.10.2024**
(21) Anmeldenummer: 22209956.6
(22) Anmeldetag: 28.11.2022
(51) Int. Cl.: B23K 1/00, B23K 1/008, B23K 1/20, H01L 21/50, H01L 23/00, H05K 3/34, B23K 101/42

(54) **VERFAHREN ZUM VERLÖTEN MINDESTENS EINES BAUTEILS MIT MINDESTENS EINEM TRÄGERELEMENT**
METHOD OF SOLDERING AT LEAST ONE COMPONENT TO AT LEAST ONE SUPPORT ELEMENT
PROCÉDÉ DE BRASAGE D'AU MOINS UN COMPOSANT AVEC AU MOINS UN ÉLÉMENT DE SUPPORT

(30) Priorität: 17.12.2021 DE 102021133746
(43) Veröffentlichungstag der Anmeldung: 05.07.2023
(73) Patentinhaber: Endress+Hauser SE+Co. KG, 79689 Maulburg (DE)
(72) Erfinder: Hippin, Christoph, 79639 Grenzach (DE); Deiß, Marlon, 79650 Schopfheim (DE)
(74) Vertreter: Koslowski, Christine Adelheid

(56) Entgegenhaltungen:
- WO-A1-90/07792
- US-A1- 2011 220 398
- US-A1- 2017 374 743

## Beschreibung

Die Erfindung betrifft ein Verfahren zum Verlöten mindestens eines Bauteils mit mindestens einem Trägerelement, wobei das mindestens eine Bauteil mindestens eine Anschlussfläche aufweist, wobei das mindestens eine Trägerelement mindestens eine Kontaktfläche aufweist, wobei die mindestens eine Anschlussfläche und die mindestens eine Kontaktfläche dazu ausgestaltet sind, miteinander verlötet zu werden.

Feldgeräte in der Prozess- und Automatisierungstechnik dienen der Überwachung und/oder Bestimmung mindestens einer, beispielsweise chemischen und/oder physikalischen, Prozessgröße eines Mediums. Im Rahmen der vorliegenden Anmeldung werden im Prinzip alle Messgeräte als Feldgerät bezeichnet, die prozessnah eingesetzt werden und die prozessrelevante Informationen liefern oder verarbeiten. Eine Vielzahl solcher Feldgeräte wird von Firmen der Endress+Hauser-Gruppe hergestellt und vertrieben.

Bei der von dem Feldgerät zu bestimmenden Prozessgröße kann es sich um den Füllstand, den Durchfluss, den Druck, die Temperatur, den pH-Wert, ein Redoxpotential, oder die Leitfähigkeit des jeweiligen Mediums handeln. Die der Bestimmung der Prozessgröße zugrundeliegenden unterschiedlichen, möglichen Messprinzipien sind aus dem Stand der Technik bekannt und werden hier nicht weiter erläutert. Feldgeräte zur Messung des Füllstands sind insbesondere als Mikrowellen-Füllstandsmessgeräte, Ultraschall-Füllstandsmessgeräte, zeitbereichsreflektometrische Füllstandsmessgeräte (TDR), radiometrische Füllstandsmessgeräte, kapazitive Füllstandsmessgeräte, konduktive Füllstandsmessgeräte und vibronische Füllstandsmessgeräte ausgestaltet. Feldgeräte zur Messung des Durchflusses dagegen arbeiten beispielsweise nach dem Coriolis-, Ultraschall-, Vortex-, thermischen und/oder magnetisch induktiven Messprinzip. Bei Druckmessgeräten handelt es sich bevorzugt um sogenannte Absolut-, Relativ- oder Differenzdruckgeräte. Neben den zuvor genannten Messgeräten und Aktoren werden unter Feldgeräten auch Remote I/Os, Funkadapter bzw. allgemein Geräte verstanden, die auf der Feldebene angeordnet sind.

Ein Feldgerät umfasst typischerweise einen zumindest teilweise und/oder zumindest zeitweise mit dem Medium des Prozesses in Berührung kommenden Sensor und eine Elektronikeinheit, welche beispielsweise der Signalerfassung, Signalauswertung und/oder Signalspeisung dient. Die Elektronikeinheit des Feldgeräts ist typischerweise in einem Gehäuse angeordnet und verfügt zusätzlich über mindestens ein Anschlusselement zum Anschluss der Elektronikeinheit an den Sensor und/oder eine externe Einheit und zum Übertragen von Daten und/oder Energie. Das Anschlusselement kann eine beliebige Verbindung sein, auch eine drahtlose Verbindung ist einsetzbar. Die Elektronikeinheit und der Sensor des Feldgeräts können in Form separater Einheiten mit getrennten Gehäusen oder als eine gemeinsame Einheit mit einem Gehäuse ausgestaltet sein.

In der Regel weist zumindest die Elektronikeinheit mindestens ein Trägerelement, wie beispielsweise eine Leiterplatte, mit darauf angeordneten Bauteilen auf, welche über mindestens eine Lötstelle zwischen einer Anschlussfläche des Bauteils und einer Kontaktfläche des Trägerelements elektrisch und mechanisch verbunden sind. Für die Ausfallsicherheit der Elektronikeinheit bzw. des Feldgeräts ist eine hohe Qualität der Lötstellen zwischen den Anschlussflächen des Bauteils und den Kontaktflächen des Trägerelements von großer Bedeutung. Die Qualität der Lötstellen ist unter anderem abhängig davon, ob der Abstand zwischen der Anschlussfläche und der Kontaktfläche (die sogenannte Lotspalthöhe) ausreichend groß ist. Bei einer zu kleinen Lotspalthöhe können z.B. zum einen unter zeitlichen Temperaturschwankungen spannungsinduzierte Risse in der Lötstelle auftreten. Insbesondere bei einem hohen Gewicht des Bauteils und der daraus resultierenden niedrigen Lotspalthöhe der Lötstelle besteht die Gefahr, dass unerwünschte Lufteinschlüsse, sogenannte Voids, innerhalb der Lötstellen gebildet werden. Dies gilt besonders dann, wenn die Anschlussflächen des Bauteils unter dem Bauteil liegen. Derartige Voids sind Folge von nicht vollständig aus der Lötstelle ausgetretenem Flussmittel, welches in dem Lot enthalten ist. Untersuchungen der Anmelderin haben gezeigt, dass bei derartigen schweren Bauteilen auch bei Einsatz von Vakuumlötverfahren Voids innerhalb der Lötstelle nicht vollständig vermieden werden können.

Ein Verfahren zur Herstellung einer Lötverbindung ist beispielsweise aus der US 2011/220398 A1 bekannt geworden.

Die Aufgabe der vorliegenden Erfindung ist es daher, ein Verfahren anzugeben, welches eine stabile und voidarme Lötstelle zwischen einem Bauteil und einer Trägerelement ermöglicht.

Erfindungsgemäß wird die Aufgabe gelöst durch ein Verfahren gemäß Anspruch 1 zum Verlöten mindestens eines Bauteils mit mindestens einem Trägerelement, wobei das mindestens eine Bauteil mindestens eine Anschlussfläche aufweist, wobei das mindestens eine Trägerelement mindestens eine Kontaktfläche aufweist, wobei die mindestens eine Anschlussfläche und die mindestens eine Kontaktfläche dazu ausgestaltet sind, miteinander verlötet zu werden, wobei das Verfahren folgende Schritte umfasst:
- Auftragen eines ersten Lots mit einer ersten Liquidustemperatur auf die mindestens eine Anschlussfläche,
- Umschmelzen des ersten Lots auf der mindestens einen Anschlussfläche bei einer Umschmelztemperatur, welche die erste Liquidustemperatur des ersten Lots überschreitet, wobei das umgeschmolzene erste Lot ein Lotdepot formt,
- Auftragen eines zweiten Lots mit einer zweiten Liquidustemperatur auf die mindestens eine Kontaktfläche, wobei das zweite Lot eine andere Zusammensetzung aufweist als das erste Lot, wobei die erste Liquidustemperatur bis zu 20 K höher ist als die zweite Liquidustemperatur,
- Positionieren des mindestens einen Bauteils relativ zum mindestens einen Trägerelement derart, dass die mindestens eine Anschlussfläche der mindestens einen Kontaktfläche zugewandt ist,
- Aufheizen des mindestens einen Bauteils und des mindestens einen Trägerelements in einem Lötofen auf eine vorgegebene Löttemperatur, derart dass eine erste Zeitspanne zwischen dem Erreichen der zweiten Liquidustemperatur und dem Erreichen der ersten Liquidustemperatur bis zu 25 s beträgt,
- Verlöten der mindestens einen Anschlussfläche mit der mindestens einen Kontaktfläche in dem Lötofen für eine zweite Zeitspanne bei der vorgegebenen Löttemperatur, welche oberhalb der ersten Liquidustemperatur und der zweiten Liquidustemperatur liegt.

In der Regel werden zum Verlöten eines Bauteils mit einem Trägerelement die Bauteile und das Trägerelement jeweils mit demselben Lot bedruckt, wobei das Lot auf dem Bauteil oder dem Trägerelement umgeschmolzen sein kann. Dasselbe Lot hat folglich eine gemeinsame Liquidustemperatur, so dass beim Lötvorgang das Lot auf dem Bauteil und das Lot auf dem Trägerelement gleichzeitig aufschmelzen.

Erfindungsgemäß werden zwei unterschiedliche Lote, das erste Lot und das zweite Lot, eingesetzt, welche sich in ihrer jeweiligen Liquidustemperatur unterscheiden. Sowohl das erste Lot als auch das zweite Lot weisen ein in dem jeweiligen Lot enthaltenes Flussmittel auf. Weist das erste Lot und/oder das zweite Lot einen Schmelzbereich auf, so ist als erste Liquidustemperatur und/oder zweite Liquidustemperatur jeweils die niedrigste Temperatur des Schmelzbereiches zu betrachten. Beim Lötvorgang wird die Temperatur im Lötofen kontinuierlich erhöht, bis eine vorgegebene Löttemperatur erreicht ist, bei der sowohl das erste Lot und das zweite Lot aufgeschmolzen werden. Dadurch, dass das zweite Lot eine niedrigere, zweite Liquidustemperatur aufweist als das erste Lot, wird das zweite Lot beim Aufheizvorgang früher aufschmelzen als das erste Lot. Je nach den verwendeten Loten kommt es zu einem zeitlichen Versatz zwischen dem Aufschmelzen des zweiten Lots und dem Aufschmelzen des ersten Lots, welcher bis zu 25 s beträgt und welcher der ersten Zeitspanne entspricht.

Während der ersten Zeitspanne bzw. des zeitlichen Versatzes schmilzt das zweite Lot also auf, während das erste Lot in Form des Lotdepots noch fest ist. Das im zweiten Lot enthaltene Flussmittel wird während des zeitlichen Versatzes bereits teilweise ausdampfen und aus dem Lot und der Lötstelle austreten. Da das Lotdepot aus dem ersten Lot noch nicht schmilzt, ist durch die Höhe des Lotdepots ein Mindestabstand zwischen der mindestens einen Anschlussfläche und der mindestens einen Kontaktfläche eingestellt, welcher das Austreten des Flussmittels aus dem zweiten Lot erleichtert. Die erste Zeitspanne sollte dabei nicht so groß gewählt sein, dass das Flussmittel wieder in das zweite Lot eintreten kann, weshalb erste Zeitspannen über 25 s zu vermeiden sind. Nach der Erhöhung der Temperatur im Lötofen auf die vorgegebene Löttemperatur schmilzt das erste Lot auf und wird mit dem zweiten Lot verlötet.

Durch das Umschmelzen des ersten Lots und das Bilden eines Lotdepots wird erreicht, dass das im ersten Lot enthaltene Flussmittel bereits zu einem großen Teil verdampft und nicht mehr im Lotdepot enthalten ist. Durch das Aufschmelzen des zweiten Lots vor dem ersten Lot wird erreicht, dass auch im zweiten Lot das Flussmittel größtenteils aus dem zweiten Lot ausgetreten ist, bevor der eigentliche Lötvorgang, welcher das Aufschmelzen von sowohl des ersten Lots als auch des zweiten Lots beinhaltet, beginnt. Damit befindet sich kaum noch oder nur noch wenig Flussmittel im ersten Lot und im zweiten Lot, welches potenziell als Lufteinschluss in der gebildeten Lötstelle verbleiben kann. Somit wird eine voidarme und stabile Lötstelle zwischen der mindestens einen Anschlussfläche und der mindestens einen Kontaktfläche gebildet.

Bevorzugt werden das erste Lot und das zweite Lot beim Verlöten der mindestens einen Anschlussfläche mit der mindestens einen Kontaktfläche in dem Lötofen vollständig aufgeschmolzen.

Vorzugsweise ist die erste Liquidustemperatur bis zu 10 K höher als die zweite Liquidustemperatur.

Insbesondere ist die erste Liquidustemperatur bis zu 5 K höher als die zweite Liquidustemperatur.

In einer Ausgestaltung beträgt die erste Zeitspanne zwischen dem Erreichen der zweiten Liquidustemperatur und dem Erreichen der ersten Liquidustemperatur bis zu 15 s.

Insbesondere beträgt die erste Zeitspanne zwischen dem Erreichen der zweiten Liquidustemperatur und dem Erreichen der ersten Liquidustemperatur bis zu 10 s.

In einer Weiterbildung liegt die vorgegebene Löttemperatur mindestens 15 K höher als die erste Liquidustemperatur.

Bevorzugt wird als das mindestens eine Trägerelement eine erste Leiterplatte verwendet. In einer Ausgestaltung wird als das mindestens eine Bauteil ein LGA-Bauteil verwendet, wobei das LGA-Bauteil eine zweite Leiterplatte mit einer auf einer ersten Oberfläche der zweiten Leiterplatte angeordneten, integrierten Schaltung verwendet wird, wobei eine Oberfläche des mindestens einen Bauteils durch eine der ersten Oberfläche gegenüberliegenden, zweiten Oberfläche der zweiten Leiterplatte gebildet ist, wobei die mindestens eine Anschlussfläche des mindestens einen Bauteils als ein auf der Oberfläche des mindestens einen Bauteils angeordneter Land Grid Array ausgeführt wird. Derartige LGA-Bauteile sind aufgrund ihrer integrierten Schaltung vergleichsweise schwere Bauteile, was bei herkömmlichen Lötvorgängen zu einer großen Anzahl an Voids in den Lötstellen zwischen dem Bauteil und dem Trägerelement führt. Das vorgeschlagene Verfahren ist für LGA-Bauteile besonders vorteilhaft, da durch das zeitlich versetzte Aufschmelzen des zweiten Lots und des ersten Lots während des Lötvorgangs durch das noch nicht aufgeschmolzene erste Lot ein Mindestabstand zwischen der mindestens einen Anschlussfläche und der mindestens einen Kontaktfläche eingestellt wird. Bei der Verwendung zweier identischer Lote führt das gleichzeitige Aufschmelzen der Lot auf der Anschlussfläche und der Kontaktfläche zu einem Sinken des LGA-Bauteils in Richtung des Trägerelements, so dass der Abstands zwischen LGA-Bauteil und Trägerelement kleiner wird und das Austreten des Flussmittels aus dem Lot erschwert wird. LGA-Bauteile weisen in der Regel eine Vielzahl an Anschlussflächen auf.

Bevorzugt wird das Umschmelzen des ersten Lots in einem Reflow-Lötofen oder einem Aushärteofen durchgeführt.

Vorzugsweise erfolgt das Verlöten der mindestens einen Anschlussfläche mit der mindestens einen Kontaktfläche in einem Reflow-Lötofen.

In einer Ausgestaltung wird ein Grenzwert für die Dauer einer thermische Belastung des mindestens einen Bauteils und/oder des mindestens einen Trägerelements angegeben, bei dessen Überschreitung das mindestens eine Bauteil und/oder das mindestens eine Trägerelement beschädigt wird. Das mindestens eine Bauteil und/oder das mindestens eine Trägerelement sind in der Regel anfällig gegenüber hohen Temperaturen und dürfen daher nur bis zu einem (zeitlichen) Grenzwert hohen Temperaturen ausgesetzt werden. Die Summe der ersten Zeitspanne und der zweiten Zeitspanne sollten den Grenzwert für die Dauer der thermischen Belastung nicht überschreiten.

Im Folgenden soll die vorliegende Erfindung anhand der nachfolgenden Figuren Fig. 1-7 näher erläutert werden. Sie zeigen:
Fig. 1: eine schematische Darstellung des Bauteils vor dem Bedrucken mit Lot.
Fig. 2: eine schematische Darstellung des Bauteils nach dem Bedrucken mit Lot.
Fig. 3: eine schematische Darstellung des Bauteils mit dem umgeschmolzenen Lotdepot.
Fig. 4: eine schematische Darstellung des Bauteils und des Trägerelements in einem Lötofen vor dem Verlöten.
Fig. 5: ein schematischer Graph des Lötvorgangs.
Fig. 6: eine schematische Darstellung einer Aufsicht auf ein LGA-Bauteil (gemäß dem Stand der Technik).
Fig. 7: eine schematische Querschnitts-Darstellung eines LGA-Bauteils (gemäß dem Stand der Technik).

Das erfindungsgemäße Verfahren dient zum Verlöten mindestens eines Bauteils 1 mit mindestens einem Trägerelement 2. Die vorliegende Erfindung ist einsetzbar in allen Arten von Feldgeräten, von denen eingangs eine nicht-beschränkende Auswahl genannt wurde.

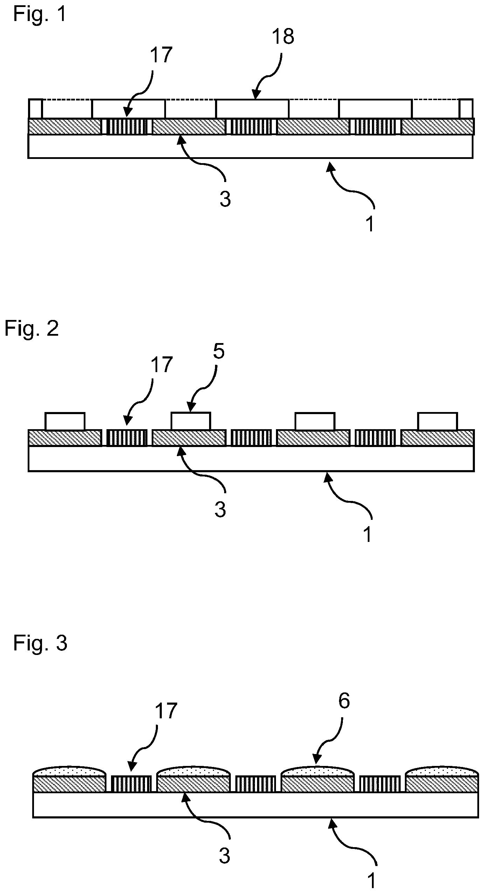

In Fig. 1 ist das mindestens eine Bauteil 1 schematisch dargestellt. Das Bauteil 1 weist mindestens eine Anschlussfläche 3 auf, welche beispielsweise durch Lötstopps 17 voneinander getrennt sind. Zusätzlich ist eine optionale Schablone 18 gezeigt, mittels der das erste Lot 5 mit einer ersten Liquidustemperatur T1 auf die mindestens eine Anschlussfläche 3 aufgetragen wird. Nach Entfernen der Schablone 18 befindet sich das Lot 5 auf den, hier beispielhaft mehreren, Anschlussflächen 3 des Bauteils 1, wie in Fig. 2 gezeigt. Anschließend wird das erste Lot 5 bei einer Umschmelztemperatur, welche die erste Liquidustemperatur T1 des ersten Lots 5 überschreitet, umgeschmolzen. Dieser Schritt des Umschmelzens des ersten Lots 5 erfolgt beispielsweise in einem Reflow-Lötofen oder einem Aushärteofen. Das umgeschmolzene erste Lot 5 bildet ein bzw. mehrere Lotdepots 6, welche in Fig. 3 schematisch dargestellt ist.

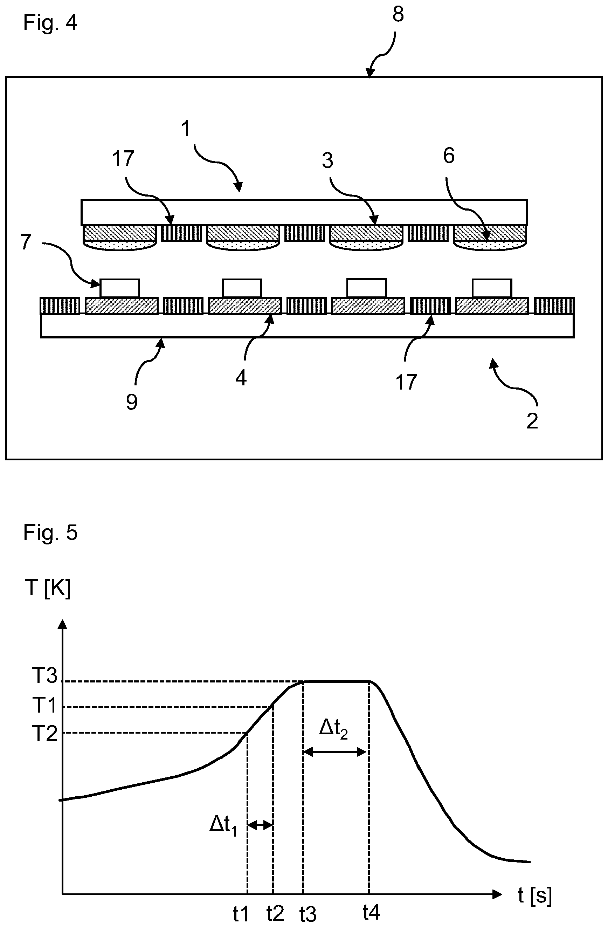

In einem nächsten Schritt wird ein zweites Lot 7, welches eine zweite Liquidustemperatur T2 aufweist, auf mindestens eine Kontaktfläche 4 des mindestens einen Trägerelements 2 aufgetragen. Das Trägerelement 2 ist beispielsweise eine erste Leiterplatte 9. Analog zu Fig. 1 kann dies beispielsweise mithilfe einer Schablone erfolgen. Ein mit dem zweiten Lot 7 bedrucktes Trägerelement 2 ist beispielhaft in Fig. 4 gezeigt. Das Trägerelement 2 wird anschließend relativ zum Bauteil 1 derart positioniert und ausgerichtet, dass die Anschlussflächen 3 den Kontaktflächen 4 zugewandt sind. Wie in Fig. 4 zu sehen, sind die Anschlussflächen 3 und die Kontaktflächen 4 im Lötofen 8 übereinander ausgerichtet. Für das Verlöten des Bauteils 1 mit dem Trägerelement 2 wird das Bauteil 1 auf das Trägerelement 2 abgesetzt (nicht gezeigt). Im gewählten Beispiel sind lediglich jeweils ein Trägerelement 2 und ein Bauteil 1 gezeigt, welche jeweils mehrere Anschlussflächen 3 bzw. Kontaktflächen 4 aufweisen. Es ist beispielsweise auch möglich, mehrere Bauteile 1 mit einem Trägerelementen 2 zu verlöten. Die mindestens eine Kontaktfläche 4 und die mindestens eine Anschlussfläche 3 sind dazu ausgestaltet, miteinander verlötet zu werden. Um eine mechanische und elektrische Verbindung zwischen dem Bauteil 1 und dem Trägerelement 2 zu erreichen, sind die mindestens eine Anschlussfläche 3 und die mindestens eine Kontaktfläche 4 elektrisch leitfähig ausgestaltet, indem sie beispielsweise mit metallisierte Oberflächen ausgestattet sind.

Das erste Lot 5 und das zweite Lot 7 weisen unterschiedliche Zusammensetzungen auf. Die erste Liquidustemperatur T1 des ersten Lots 5 ist bis zu 20 K, insbesondere bis zu 10 K, insbesondere bis zu 5 K, höher als die zweite Liquidustemperatur T2 des zweiten Lots 7. Das Bauteil 1 und das Trägerelement 2 werden im Lötofen 8 auf eine vorgegebene Löttemperatur T3 aufgeheizt, wobei eine erste Zeitspanne Δt₁ zwischen dem Erreichen der (niedrigeren) zweiten Liquidustemperatur T2 und der (höheren) ersten Liquidustemperatur T1 bis zu 25 s, insbesondere bis zu 15 s, insbesondere bis zu 10 s, beträgt.

Der Temperaturverlauf beim Verlöten des Bauteils 1 und des Trägerelements 2 ist schematisch in der Fig. 5 dargestellt. Die Temperatur T steigt mit der Zeit t an, während der Lötofen 8 aufgeheizt wird. Dabei wird zu einem Zeitpunkt t1 zunächst die zweite Liquidustemperatur T2 des zweiten Lots 7 erreicht. Bis zum Erreichen der ersten Liquidustemperatur T1 des ersten Lots 5 vergeht die erste Zeitspanne Δt₁ = t2 - t1. Innerhalb der ersten Zeitspanne Δt₁ wird das zweite Lot 7 aufgeschmolzen und das Flussmittel kann bereits aus dem zweiten Lot 7 austreten, während das erste Lot 5 noch nicht begonnen hat aufzuschmelzen. Die Höhe des Lotdepots 6 des ersten Lots 5 über den Anschlussflächen 3 gibt damit einen Mindestabstand vor, unter den der Abstand zwischen Anschlussflächen 3 und Kontaktflächen 4 nicht sinken kann. Das Flussmittel kann somit auf einfache Weise aus dem zweiten Lot 7 austreten und verdampfen. Auch das erste Lot 5 enthält ursprünglich Flussmittel, welches aber bereits beim Umschmelzen des ersten Lots 5 größtenteils aus dem ersten Lot 5 austritt.

Nach dem Überschreiten der ersten Liquidustemperatur T1 erreicht der Lötofen 8 schließlich eine vorgegebene Löttemperatur T3, welche oberhalb der ersten Liquidustemperatur T1 und der zweiten Liquidustemperatur T2 liegt und bei welcher das Verlöten der Anschlussflächen 3 mit den Kontaktflächen 4 stattfindet. Insbesondere werden das erste Lot 5 und das zweite Lot 7 beim Verlöten der Anschlussflächen 3 mit den Kontaktflächen 4 vollständig aufgeschmolzen. Das Verlöten der Anschlussflächen 3 mit den Kontaktflächen 4 erfolgt beispielsweise in einem Reflow-Lötofen. Die vorgegebene Löttemperatur T3 wird für eine zweite Zeitspanne Δt₂ = t4 - t3 aufrechterhalten, bevor das miteinander verlötete Bauteil 1 und das Trägerelement 2 abgekühlt werden. Beispielsweise beträgt die zweite Zeitspanne Δt₂ zwischen 30 s und 90 s, insbesondere zwischen 30 s und 70 s. Die vorgegebene Löttemperatur T3 liegt optional mindestens 15 K höher als die erste Liquidustemperatur T1. Die Abstände zwischen den verschiedenen Temperaturen und Zeitpunkte werden in Fig. 5 lediglich schematisch gezeigt, es können keine absoluten Werte oder Relationen aus Fig. 5 abgeleitet werden.

Beispielsweise kann das erste Lot 5 eine erste Liquidustemperatur T1 von etwa 227°C aufweisen und das zweite Lot 7 eine zweite Liquidustemperatur T2 von 217°C. Die Differenz der beiden Liquidustemperaturen T1,T2 beträgt somit etwa 10°C. Die erste Zeitspanne Δt₁ beträgt beispielsweise ca. 9 s. Die zweite Zeitspanne Δt₂ beträgt beispielsweise etwa 30 bis 70 s.

Ferner kann ein Grenzwert für die Dauer einer thermische Belastung des mindestens einen Bauteils und/oder des mindestens einen Trägerelements 2 angegeben werden, bei dessen Überschreitung das mindestens eine Bauteil 1 und/oder das mindestens eine Trägerelement 2 beschädigt wird. Dieser Grenzwert ist bei der Auslegung der ersten Zeitspanne Δt₁ und/oder der zweiten Zeitspanne Δt₂ zu berücksichtigen.

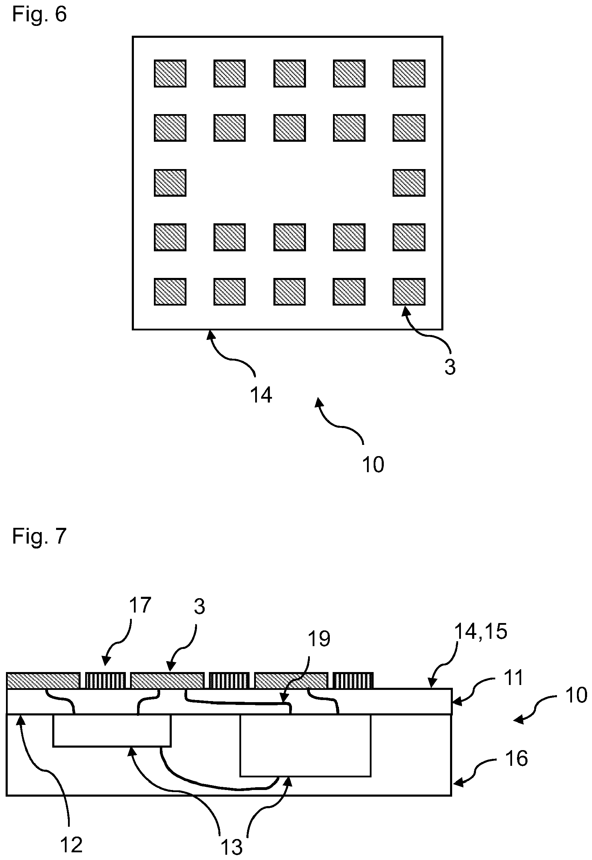

In Fig. 6 ist ein beispielhaftes Bauteil 1 in der Aufsicht gezeigt. Das Bauteil 1 ist in diesem Beispiel ein LGA-Bauteil 10, welches mehrere Anschlussflächen 3 aufweist, die auf der Oberfläche 14 des LGA-Bauteils 10 in Form eines Land Grid Array ausgeführt sind. Durch die Größe und das Gewicht des LGA-Bauteils 10 kann das Flussmittel insbesondere aus den innenliegenden Anschlussflächen 3 bei herkömmlichen Lötverfahren nur schwer und unvollständig aus dem Lot austreten, so dass eine hohe Zahl an Lufteinschlüssen in den gebildeten Lötstellen vorliegen.

Fig. 7 zeigt einen schematischen Querschnitt durch ein LGA-Bauteil 10. Auf einer ersten Oberfläche 12 einer zweiten Leiterplatte 11 ist eine integrierte Schaltung 13 angeordnet, welche optional in einem Gehäuse 16 angeordnet ist. Die zweite Oberfläche 15 der zweiten Leiterplatte 11 liegt der ersten Oberfläche 12 gegenüber und bildet die Oberfläche 14 des LGA-Bauteils 10. Die integrierte Schaltung ist über Verbindungen 19 mit den Anschlussflächen 3 elektrisch verbunden.

### Bezugszeichenliste

- 1: Bauteil
- 2: Trägerelement
- 3: Anschlussfläche
- 4: Kontaktfläche
- 5: erstes Lot
- 6: Lotdepot des ersten Lots
- 7: zweites Lot
- 8: Lötofen
- 9: erste Leiterplatte
- 10: LGA-Bauteil
- 11: zweite Leiterplatte
- 12: erste Oberfläche der zweiten Leiterplatte
- 13: integrierte Schaltung
- 14: Oberfläche des Bauteils
- 15: zweite Oberfläche des zweiten Leiterplatte
- 16: Gehäuse
- 17: Lötstopp
- 18: Schablone
- 19: Verbindung

- T1: erste Liquidustemperatur des ersten Lots
- T2: zweite Liquidustemperatur des zweiten Lots
- T3: vorgegebene Löttemperatur
- Δt₁: erste Zeitspanne
- Δt₂: zweite Zeitspanne

## Patentansprüche

1. Verfahren zum Verlöten mindestens eines Bauteils (1) mit mindestens einem Trägerelement (2), wobei das mindestens eine Bauteil (1) mindestens eine Anschlussfläche (3) aufweist, wobei das mindestens eine Trägerelement (2) mindestens eine Kontaktfläche (4) aufweist, wobei die mindestens eine Anschlussfläche (3) und die mindestens eine Kontaktfläche (4) dazu ausgestaltet sind, miteinander verlötet zu werden, wobei das Verfahren folgende Schritte umfasst:
- Auftragen eines ersten ein erstes Flussmittel enthaltenden Lots (5) mit einer ersten Liquidustemperatur (T1) auf die mindestens eine Anschlussfläche (3),
- Umschmelzen des ersten Lots (5) auf der mindestens einen Anschlussfläche (3) bei einer Umschmelztemperatur, welche die erste Liquidustemperatur (T1) des ersten Lots (5) überschreitet, wobei das umgeschmolzene erste Lot (5) ein Lotdepot (6) formt,
**gekennzeichnet durch** die folgenden Schritte:
- Auftragen eines zweiten ein zweites Flussmittel enthaltenden Lots (7) mit einer zweiten Liquidustemperatur (T2) auf die mindestens eine Kontaktfläche (4), wobei das zweite Lot (7) eine andere Zusammensetzung aufweist als das erste Lot (5), wobei die erste Liquidustemperatur (T1) sich von der zweiten Liquidustemperatur (T2) unterscheidet und bis zu 20 K höher ist als die zweite Liquidustemperatur (T2),
- Positionieren des mindestens einen Bauteils (1) relativ zum mindestens einen Trägerelement (2) derart, dass die mindestens eine Anschlussfläche (3) der mindestens einen Kontaktfläche (4) zugewandt ist,
- Aufheizen des mindestens einen Bauteils (1) und des mindestens einen Trägerelements (2) in einem Lötofen (8) auf eine vorgegebene Löttemperatur (T3), derart dass eine erste Zeitspanne (Δt₁) zwischen dem Erreichen der zweiten Liquidustemperatur (T1) und dem Erreichen der ersten Liquidustemperatur (T2) bis zu 25 s beträgt, wobei das zweite Lot während der ersten Zeitspanne (Δt₁) aufschmilzt, während das erste Lot noch fest ist,
- Verlöten der mindestens einen Anschlussfläche (3) mit der mindestens einen Kontaktfläche (4) in dem Lötofen (8) für eine zweite Zeitspanne (Δt₂) bei der vorgegebenen Löttemperatur (T3), welche oberhalb der ersten Liquidustemperatur (T1) und der zweiten Liquidustemperatur (T2) liegt.

2. Verfahren nach Anspruch 1,
wobei das erste Lot (5) und das zweite Lot (7) beim Verlöten der mindestens einen Anschlussfläche (3) mit der mindestens einen Kontaktfläche (4) in dem Lötofen (8) vollständig aufgeschmolzen werden.

3. Verfahren nach mindestens einem der Ansprüche 1-2,
wobei die erste Liquidustemperatur (T1) bis zu 10 K höher ist als die zweite Liquidustemperatur (T2).

4. Verfahren nach mindestens einem der Ansprüche 1-3,
wobei die erste Liquidustemperatur (T1) bis zu 5 K höher ist als die zweite Liquidustemperatur (T2).

5. Verfahren nach mindestens einem der Ansprüche 1-4,
wobei die erste Zeitspanne (Δt₁) zwischen dem Erreichen der zweiten Liquidustemperatur (T2) und dem Erreichen der ersten Liquidustemperatur (T1) bis zu 15 s beträgt.

6. Verfahren nach mindestens einem der Ansprüche 1-5,
wobei die erste Zeitspanne (Δt₁) zwischen dem Erreichen der zweiten Liquidustemperatur (T2) und dem Erreichen der ersten Liquidustemperatur (T1) bis zu 10 s beträgt.

7. Verfahren nach mindestens einem der Ansprüche 1-6,
wobei die vorgegebene Löttemperatur mindestens 15 K höher liegt als die erste Liquidustemperatur (T1).

8. Verfahren nach mindestens einem der Ansprüche 1-7,
wobei als das mindestens eine Trägerelement (2) eine erste Leiterplatte (9) verwendet wird.

9. Verfahren nach mindestens einem der Ansprüche 1-8,
wobei als das mindestens eine Bauteil (1) ein LGA-Bauteil (10) verwendet wird,
wobei das LGA-Bauteil (10) eine zweite Leiterplatte (11) mit einer auf einer ersten Oberfläche (12) der zweiten Leiterplatte (11) angeordneten, integrierten Schaltung (13) verwendet wird, wobei eine Oberfläche (14) des mindestens einen Bauteils (1) durch eine der ersten Oberfläche (12) gegenüberliegenden, zweiten Oberfläche (15) der zweiten Leiterplatte (11) gebildet ist, wobei die mindestens eine Anschlussfläche (3) des mindestens einen Bauteils (1) als ein auf der Oberfläche (14) des mindestens einen Bauteils (1) angeordneter Land Grid Array ausgeführt wird.

10. Verfahren nach mindestens einem der Ansprüche 1-9,
wobei das Umschmelzen des ersten Lots (5) in einem Reflow-Lötofen oder einem Aushärteofen durchgeführt wird.

11. Verfahren nach mindestens einem der Ansprüche 1-10,
wobei das Verlöten der mindestens einen Anschlussfläche (3) mit der mindestens einen Kontaktfläche (4) in einem Reflow-Lötofen erfolgt.

12. Verfahren nach mindestens einem der Ansprüche 1-11,
wobei ein Grenzwert für die Dauer einer thermische Belastung des mindestens einen Bauteils (1) und/oder des mindestens einen Trägerelements (2) angegeben wird, bei dessen Überschreitung das mindestens eine Bauteil (1) und/oder das mindestens eine Trägerelement (2) beschädigt wird.

## Claims

1. A method for soldering at least one component (1) with at least one carrier element (2), wherein the at least one component (1) has at least one connecting surface (3), wherein the at least one carrier element (2) has at least one contact surface (4), wherein the at least one connecting surface (3) and the at least one contact surface (4) are designed to be soldered together, wherein the method comprises the following steps:
- Applying a first solder (5) containing a first flux with a first liquidus temperature (T1) to the at least one connecting surface (3),
- Remelting the first solder (5) on the at least one connecting surface (3) at a remelting temperature, which is higher than the first liquidus temperature (T1) of the first solder (5), wherein the remelted first solder (5) forms a solder deposit (6),
**characterized by** the following steps:
- Applying a second solder (7) containing a second flux with a second liquidus temperature (T2) to the at least one contact surface (4), wherein the second solder (7) has a different composition to the first solder (5), wherein the first liquidus temperature (T1) is different from the second liquidus temperature (T2) and is up to 20 K higher than the second liquidus temperature (T2),
- Positioning the at least one component (1) relative to the at least one carrier element (2) in such a way that the at least one connecting surface (3) is facing the at least one contact surface (4),
- Heating the at least one component (1) and the at least one carrier element (2) in a soldering oven (8) to a specified soldering temperature (13) in such a way that a first time period (Δt1) from when the second liquidus temperature (T2) is reached until when the first liquidus temperature (T1) is reached lasts for up to 25 s, wherein the second solder melts during the first time period (Δt1) while the first solder remains solid,
- Soldering the at least one connecting surface (3) to the at least one contact surface (4) in a soldering oven (8) for a second time period (Δt2) at the specified soldering temperature (T3), which is above the first liquidus temperature (T1) and the second liquidus temperature (T2).

2. The method as claimed in claim 1,
wherein the first solder (5) and the second solder (7) are completely melted when the at least one connecting surface (3) is soldered to the at least one contact surface (4) in a soldering oven (8).

3. The method as claimed in at least one of claims 1 and 2,
wherein the first liquidus temperature (T1) is up to 10 K higher than the second liquidus temperature (T2).

4. The method as claimed in at least one of claims 1 to 3,
wherein the first liquidus temperature (T1) is up to 5 K higher than the second liquidus temperature (T2).

5. The method as claimed in at least one of claims 1 to 4,
wherein the first time period (Δt1) from when the second liquidus temperature (T2) is reached until when the first liquidus temperature (T1) is reached lasts for up to 15 s.

6. The method as claimed in at least one of claims 1 to 5,
wherein the first time period (Δt1) from when the second liquidus temperature (T2) is reached until when the first liquidus temperature (T1) is reached lasts for up to 10 s.

7. The method as claimed in at least one of claims 1 to 6,
wherein the specified soldering temperature is at least 15 K higher than the first liquidus temperature (T1).

8. The method as claimed in at least one of claims 1 to 7,
wherein a first PCB (9) is used as the at least one carrier element (2).

9. The method as claimed in at least one of claims 1 to 8,
wherein an LGA component (10) is used as the at least one component (1),
wherein a second PCB (11) with an integrated circuit (13) arranged on a first surface (12) of the second PCB (11) is used
as the LGA component (10), wherein one surface (14) of the at least one component (1) is formed by a second surface (15) of the second PCB (11) which is opposite the first surface (12), wherein the at least
one connection surface (3) of the at least one component (1) is configured as a land grid array arranged on the surface (14) of the at least one component (1).

10. The method as claimed in at least one of claims 1 to 9,
wherein the first solder (5) is remelted in a reflow soldering oven or a curing oven.

11. The method as claimed in at least one of claims 1 to 10,
wherein the at least one connecting surface (3) is soldered to the at least one contact surface (4) in a reflow soldering oven.

12. The method as claimed in at least one of claims 1 to 11,
wherein a limit value for the duration of thermal loading of the at least one component (1) and/or the at least one carrier element (2) is specified which, if exceeded, will result in damage to the at least one component (1) and/or the at least one carrier element (2).

## Revendications

1. Procédé destiné au soudage d'au moins un composant (1) avec au moins un élément de support (2), l'au moins un composant (1) présentant au moins une surface de connexion (3), l'au moins un élément de support (2) présentant au moins une surface de contact (4), l'au moins une surface de connexion (3) et l'au moins une surface de contact (4) étant conçues pour être soudées ensemble, lequel procédé comprend les étapes suivantes :
- Application d'une première soudure (5) contenant un premier flux avec une première température de liquidus (T1) sur l'au moins une surface de connexion (3),
- Refusion de la première soudure (5) sur l'au moins une surface de connexion (3) à une température de refusion, laquelle dépasse la première température de liquidus (T1) de la première soudure (5), la première soudure (5) refondue formant un dépôt de soudure (6),
**caractérisé par** les étapes suivantes :
- Application d'une deuxième soudure (7) contenant un deuxième flux avec une deuxième température de liquidus (T2) sur l'au moins une surface de contact (4), la deuxième soudure (7) présentant une composition différente de celle de la première soudure (5), la première température de liquidus (T1) étant différente de la deuxième température de liquidus (T2) et étant jusqu'à 20 K supérieure à la deuxième température de liquidus (T2),
- Positionnement de l'au moins un composant (1) par rapport à l'au moins un élément de support (2) de telle sorte que l'au moins une surface de connexion (3) soit tournée vers l'au moins une surface de contact (4),
- Échauffement de l'au moins un composant (1) et de l'au moins un élément de support (2) dans un four de soudage (8) à une température de soudage (T3) prédéfinie, de telle sorte qu'un premier intervalle de temps (Δt₁) entre l'atteinte de la deuxième température de liquidus (T2) et l'atteinte de la première température de liquidus (T1) soit inférieur ou égal à 25 s, la deuxième soudure fondant pendant le premier intervalle de temps (Δt₁), tandis que la première soudure est encore solide,
- Soudage de l'au moins une surface de connexion (3) à l'au moins une surface de contact (4) dans le four de soudage (8) pendant un deuxième intervalle de temps (Δt₂) à la température de soudage prédéterminée (T3), laquelle température est supérieure à la première température de liquidus (T1) et à la deuxième température de liquidus (T2).

2. Procédé selon la revendication 1,
pour lequel la première soudure (5) et la deuxième soudure (7) sont entièrement fondues dans le four de soudage (8) lors du soudage de l'au moins une surface de connexion (3) avec l'au moins une surface de contact (4).

3. Procédé selon au moins l'une des revendications 1 à 2,
pour lequel la première température de liquidus (T1) est jusqu'à 10 K supérieure à la deuxième température de liquidus (T2).

4. Procédé selon au moins l'une des revendications 1 à 3,
pour lequel la première température de liquidus (T1) est jusqu'à 5 K supérieure à la deuxième température de liquidus (T2).

5. Procédé selon au moins l'une des revendications 1 à 4,
pour lequel le premier intervalle de temps (Δt₁) entre l'atteinte de la deuxième température de liquidus (T2) et l'atteinte de la première température de liquidus (T1) est inférieur ou égal à 15 secondes.

6. Procédé selon au moins l'une des revendications 1 à 5,
pour lequel le premier intervalle de temps (Δt₁) entre l'atteinte de la deuxième température de liquidus (T2) et l'atteinte de la première température de liquidus (T1) est inférieur ou égal à 10 secondes.

7. Procédé selon au moins l'une des revendications 1 à 6,
pour lequel la température de soudage prédéfinie est supérieure d'au moins 15 K à la première température de liquidus (T1).

8. Procédé selon au moins l'une des revendications 1 à 7,
pour lequel une première carte de circuit imprimé (9) est utilisée comme l'au moins un élément de support (2).

9. Procédé selon au moins l'une des revendications 1 à 8,
pour lequel on utilise comme l'au moins un composant (1) un composant LGA (10), le composant LGA (10) étant une deuxième carte de circuit imprimé (11) avec un circuit intégré (13) disposé sur une première surface (12) de la deuxième carte de circuit imprimé (11), une surface (14) de l'au moins un composant (1) étant formée par une deuxième surface (15) de la deuxième carte de circuit imprimé (11), laquelle deuxième surface est opposée à la première surface (12), l'au moins une surface de connexion (3) de l'au moins un composant (1) étant réalisée sous la forme d'une matrice de pastilles (LGA - Land Grid Array) disposée sur la surface (14) de l'au moins un composant (1).

10. Procédé selon au moins l'une des revendications 1 à 9,
pour lequel la refusion de la première soudure (5) est réalisée dans un four de soudage par refusion ou dans un four de durcissement.

11. Procédé selon au moins l'une des revendications 1 à 10,
pour lequel le soudage de l'au moins une surface de connexion (3) avec l'au moins une surface de contact (4) est réalisé dans un four de soudage par refusion.

12. Procédé selon au moins l'une des revendications 1 à 11,
pour lequel on indique une valeur limite pour la durée d'une charge thermique de l'au moins un composant (1) et/ou de l'au moins un élément de support (2), valeur limite au-delà de laquelle l'au moins un composant (1) et/ou l'au moins un élément de support (2) est endommagé.
